# EUROPEAN PATENT SPECIFICATION

(11) **EP 4 020 800 B1**
(45) Date of publication and mention of the grant of the patent: **09.04.2025**
(21) Application number: 21210875.7
(22) Date of filing: 26.11.2021
(51) Int. Cl.: H03F 1/08, H03F 1/32, H03F 3/217, H03F 3/24, H03M 1/06, H03M 1/66, H04B 1/04

(54) **INVERTER CIRCUIT, DIGITAL-TO-ANALOG CONVERSION CELL, DIGITAL-TO-ANALOG CONVERTER, TRANSMITTER, BASE STATION AND MOBILE DEVICE**
WECHSELRICHTERSCHALTUNG, DIGITAL-ANALOG-UMWANDLUNGSZELLE, DIGITAL-ANALOG-WANDLER, SENDER, BASISSTATION UND MOBILE VORRICHTUNG
CIRCUIT D'INVERSEUR, CELLULE DE CONVERSION NUMÉRIQUE-ANALOGIQUE, CONVERTISSEUR NUMÉRIQUE-ANALOGIQUE, TRANSMETTEUR, STATION DE BASE ET DISPOSITIF MOBILE

(30) Priority: 23.12.2020 US 202017131813
(43) Date of publication of application: 29.06.2022
(73) Proprietor: INTEL Corporation, Santa Clara, CA 95054 (US)
(72) Inventor: GRUBER, Daniel, 9433 St. Andrä (AT); CLARA, Martin, Santa Clara, 95050 (US); CANGIANIELLO, Alessandra, 9500 Villach (AT)
(74) Representative: 2SPL Patentanwälte PartG mbB

(56) References cited:
- US-B2- 9 490 834
- ABDULSLAM ABDULLAH ET AL: "A Symmetric Modified Multilevel Ladder PMIC for Battery-Connected Applications", IEEE JOURNAL OF SOLID-STATE CIRCUITS, IEEE, USA, vol. 55, no. 3, 18 December 2019 (2019-12-18), pages 767 - 780, XP011774182, ISSN: 0018-9200, [retrieved on 20200224], DOI: 10.1109/JSSC.2019.2957658

## Description

### Field

The present disclosure relates to inverters. In particular, examples of the present disclosure relate to an inverter circuit, a digital-to-analog conversion cell comprising the inverter circuit, a Digital-to-Analog Converter (DAC) comprising the digital-to-analog conversion cell, a transmitter comprising the DAC, a base station comprising the transmitter and a mobile device comprising the transmitter.

### Background

Document Abdulslam Abdullah et al.: "A Symmetric Modified Multilevel Ladder PMIC for Battery-Connected Applications", IEEE JOURNAL OF SOLID-STATE CIRCUITS, IEEE, USA, vol. 55, no. 3, 18 December 2019 (2019-12-18), pages 767-780, XP011774182, ISSN: 0018-9200, DOI: 10.1109/JSSC.2019.2957658 proposes a Symmetric Modified Multilevel Ladder (SMML) converter for directly converting down from Li-ion battery voltage ranges to System on Chip (SoC) compatible voltage ranges while using low-voltage power Metal Oxide Semiconductor Field-Effect Transistors (MOSFETs) in the power stage. Cascode buck converters with multiple stacked MOSFETs for both a low-side and a high-side switches are used. Flying capacitors are provided between MOSFETs of the low-side and the high-side switches. Patent US 9 490 834 B2 discloses digital-to-analog converter using switched-capacitor cells comprising inverter based structures.

An inverter-based digital-to-analog conversion cell in a DAC suffers from parasitic resistances and capacitances. The linearity of DACs suffers from these parasitic resistances and capacitances. In particular at high operating frequencies, the effects of the parasitic capacitances are no longer negligible.

Hence, there may be a desire for improved inverter circuitry.

### Brief description of the Figures

Some examples of apparatuses and/or methods will be described in the following by way of example only, and with reference to the accompanying figures, in which
Fig. 1 illustrates a first example of an inverter circuit in a digital-to-analog conversion cell;
Fig. 2 illustrates a second example of an inverter circuit in a digital-to-analog conversion cell;
Fig. 3 illustrates a third example of an inverter circuit in a digital-to-analog conversion cell;
Fig. 4 illustrates a fourth example of an inverter circuit in a digital-to-analog conversion cell;
Fig. 5 illustrates a fifth example of an inverter circuit in a digital-to-analog conversion cell;
Fig. 6 illustrates an example of a DAC;
Fig. 7 illustrates an exemplary comparison of Spurious-Free Dynamic Ranges (SFDRs);
Fig. 8 illustrates a first exemplary DAC output spectrum;
Fig. 9 illustrates a second exemplary DAC output spectrum;
Fig. 10 illustrates an example of a base station; and
Fig. 11 illustrates an example of a mobile device.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

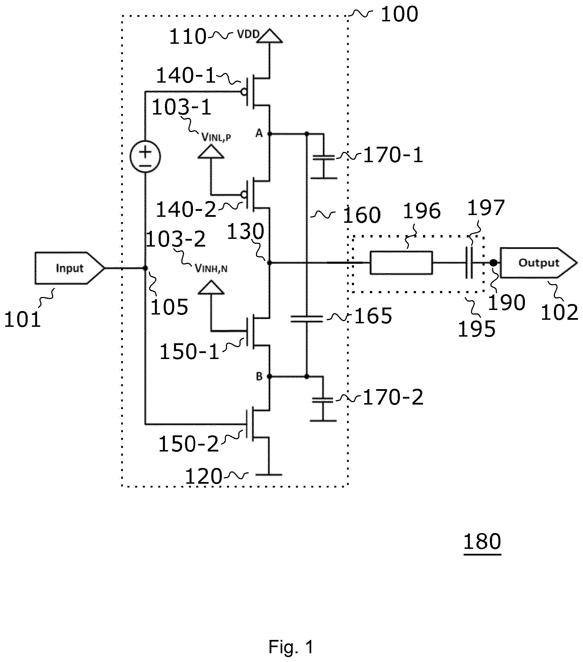

**Fig. 1** illustrates a first example of an inverter circuit 100. The inverter circuit 100 comprises a first node 110 for coupling to (receiving) a first electrical potential (e.g. a positive supply voltage V_{DD}). Further, the inverter circuit 100 comprises a second node 120 for coupling to (receiving) a second electrical potential (e.g. a negative supply voltage V_{SS} or ground) different from the first electrical potential. The inverter circuit 100 additionally comprises a third node 130 coupled between the first node 110 and the second node 120. The third node 130 is configured to output an output signal of the inverter circuit 100.

The inverter circuit 100 comprises two transistors 140-1 and 140-2 of a first conductivity type. In the example of Fig. 1, the transistors 140-1 and 140-2 are p-type (p-channel) transistors. However, it is to be noted that the transistors 140-1 and 140-2 may be n-type (n-channel) transistors in other examples. The transistors 140-1 and 140-2 are coupled in series between the first node 110 and the third node 130. In the example, of Fig. 1, two transistors 140-1 and 140-2 are illustrated. However, it is to be noted that the present disclosure is not limited thereto. In general, any number N ≥ 2 of transistors of the first conductivity type may be coupled in series between the first node 110 and the third node 130 (N being an integer). In more general terms, a plurality of transistors of the first conductivity type is coupled in series between the first node 110 and the third node 130.

The inverter circuit 100 comprises two transistors 150-1 and 150-2 of a second conductivity type, which is different from the first conductivity type. In the example of Fig. 1, the transistors 150-1 and 150-2 are n-type (n-channel) transistors as the transistors 140-1 and 140-2 are p-type transistors. However, it is to be noted that the transistors 150-1 and 150-2 may be p-type (p-channel) transistors in other examples in which the transistors 140-1 and 140-2 are n-type transistors. The transistors 150-1 and 150-2 are coupled in series between the third node 130 and the second node 120. In the example, of Fig. 1, two transistors 150-1 and 150-2 are illustrated. However, it is to be noted that the present disclosure is not limited thereto. In general, any number M ≥ 2 of transistors of the second conductivity type may be coupled in series between the third node 130 and the second node 120 (M being an integer which may be equal to or be different from N). In more general terms, a plurality of transistors of the second conductivity type is coupled in series between the third node 130 and the second node 120.

The inverter circuit 100 additionally comprises a fourth node 105 configured to receive an input signal 101 which is a digital signal such as a digital oscillation/control/activation signal) that is to be inverted. The fourth node 105 is coupled to a gate (control) terminal of the transistor 140-1 of the first conductivity type and a gate (control) terminal of the transistor 150-2 of the second conductivity type. However, it is to be noted that the present disclosure is not limited thereto. In other examples, the fourth node 105 may alternatively be coupled to a gate terminal of the transistor 140-2 of the first conductivity type and a gate terminal of the transistor 150-1 of the second conductivity type. In more general terms, the fourth node is coupled to a gate terminal of one of the plurality of transistors of the first conductivity type and a gate terminal of one of the plurality of transistors of the second conductivity type.

A gate terminal of the of the transistor 140-2 of the first conductivity type is configured to receive a fixed electrical potential 103-1 to (e.g. selectively) keep the transistor 140-2 in a conductive state (e.g. a bias voltage signal or an enable signal). Similarly, a gate terminal of the transistor 150-1 of the second conductivity type is configured to receive a fixed electrical potential 103-2 to (e.g. selectively) keep the transistor 150-1 in a conductive state (e.g. a bias voltage signal or an enable signal). The gate terminals of the of the transistors 140-2 and 150-1 may be coupled to a respective node configured to receive the respective fixed electrical potential. In more general terms, the gate terminals of the other transistors of the plurality of transistors of the first conductivity type and the plurality of transistors of the second conductivity type (i.e. the transistors other than the one transistor of the plurality of transistors of the first conductivity type and the one transistor of the plurality of transistors of the second conductivity type that are coupled to the fourth node 105) are configured to receive a respective fixed electrical potential.

The transistors 140-1 and 140-2 are serially coupled pull-up transistors that allow to selectively couple the third node 130 to the first electrical potential based on the input signal 101. Analogously, the transistors 150-1 and 150-2 are serially coupled pull-down transistors that allow to selectively couple the third node 130 to the second electrical potential based on the input signal 101. Accordingly, the output signal of the inverter circuit at the third node 130 is inverted with respect to the input signal 101.

The cascode formed by the transistors 140-1 and 140-2 suffers from parasitic capacitances. These parasitic capacitances are indicated by the parasitic capacitor 170-1 coupled to a node A between the transistors 140-1 and 140-2. Similarly, the cascode formed by the transistors 150-1 and 150-2 suffers from parasitic capacitances. These parasitic capacitances are indicated by the parasitic capacitor 170-2 coupled to a node B between the transistors 150-1 and 150-2.

While the parasitic capacitances at the nodes A and B may be negligible (tolerable) in case a frequency of the input signal 101 is low (e.g. below 1 GHz), the parasitic capacitances cause additional harmonic distortions in the output signal of the inverter circuit 100 for higher frequencies.

The charging and discharging behaviour of the parasitic capacitance at nodes A and B affects the linearity of the inverter circuit 100. Assuming that the transistor 140-1 is fully off (i.e. in a non-conducting state) and that the gate voltage at the transistors 140-1 is at V_{DD} (i.e. the input signal 101 indicates a digital one), the parasitic capacitor 170-1 at the node A is discharged. Once the input signal 101 changes to V_{IN,L} (i.e. the input signal 101 indicates a digital zero), the transistor 140-1 switches to the conductive state and the current flowing from the transistor 140-1 into the node A splits into two branches during a certain time interval. In particular, a part of the current is flowing to the other transistors 140-2 while another part of the current is flowing to the parasitic capacitor 170-1 at the node A until the parasitic capacitor 170-1 is fully charged. If the frequency of the input signal 101 is low enough that the time to charge and discharge the parasitic capacitor 170-1 is negligible compared to the switching period of the input signal 101, the linearity of the inverter circuit 100 is hardly affected. However, if the frequency of the input signal 101 is so high that the time to charge and discharge the parasitic capacitor 170-1 is not negligible compared to the switching period of the input signal 101, the linearity of the inverter circuit 100 is decreased.

In order to support the charging and discharging of the parasitic capacitances, the inverter circuit 100 additionally comprises a coupling path 160 comprising a capacitive element 165 (e.g. a single capacitor or a plurality of coupled capacitors). The coupling path 160 is coupled to the nodes A and B such that the coupling path 160 is coupled to a source terminal of the transistor 140-2 and a source terminal of the transistor 150-1.

The charge state of the coupling path 160, in particular the capacitive element 165, changes dynamically with the input signal 101. The current (charges) flowing into the capacitive element 165 support the charging and discharging of the parasitic capacitances (indicated by the parasitic capacitors 170-1 and 170-2) such that the on- and off-switching of the transistors 140-1 and 150-2 is no longer influenced by the parasitic capacitances. Accordingly, a linearity of the inverter circuit 100 may be increased compared to conventional inverter circuitry - in particular if the frequency of the input signal 101 is above 1 GHz.

In other words, a capacitor is added between the switch and the cascode device of each of the pull-up network and the pull-down network by means of the coupling path in order to charge and discharge the parasitic capacitances.

For example, a capacitance of the capacitive element 165 may be equal to or greater than a gate-source capacitance C_{gs} of any of the plurality of transistors of the first conductivity type. Similarly, the capacitance of the capacitive element 165 may be equal to or greater than a gate-source capacitance C_{gs} of any of the plurality of transistors of the second conductivity type. The capacitance of the capacitive element may, e.g., be at least three times and at maximum five times the gate-source capacitance C_{gs} of any of the plurality of transistors of the first conductivity type and/or any of the plurality of transistors of the second conductivity type. Accordingly to examples, the capacitance of the capacitive element 165 may, e.g., be four times the gate-source capacitance C_{gs} of any of the plurality of transistors of the first conductivity type and/or any of the plurality of transistors of the second conductivity type.

In the example of Fig. 1, the inverter circuit 100 is shown as part of a digital-to-analog conversion cell 180. However, it is to be noted that inverter circuits according to the present disclosure are not limited to being used in digital-to-analog conversion cells. In general, the inverter circuits according to the present disclosure may be used for any application that requires signal inversion.

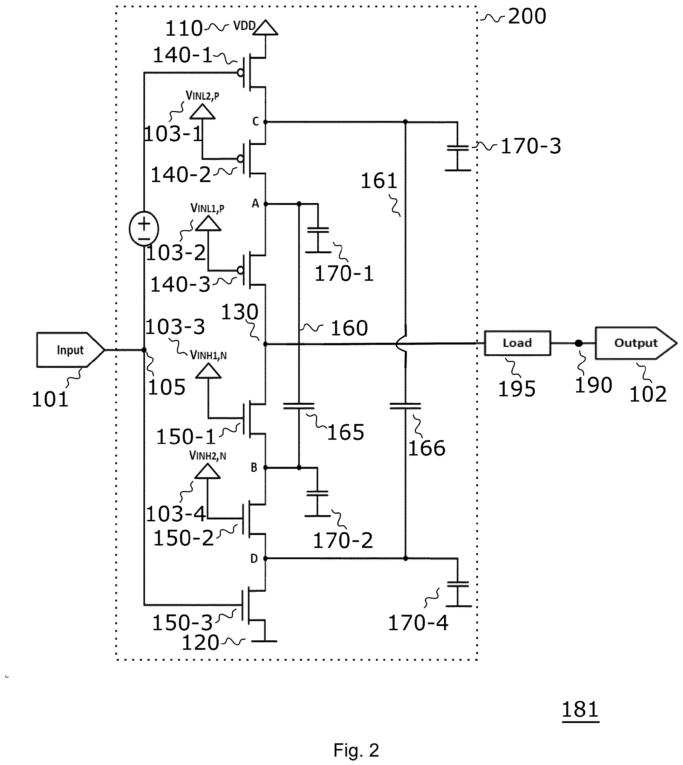

In addition to the inverter circuit 100, the digital-to-analog conversion cell 180 comprises a cell output node 190 configured to provide an analog output signal 102 of the digital-to-analog conversion cell 180. A load 195 is coupled between the inverter circuit 100 and the cell output node 190. The load 195 receives the output signal of the inverter circuit 100 and generates the analog output signal 102 based thereon. In the example of Fig. 2, the load 195 is combination of a resistive element 196 (e.g. a single resistor or a plurality of coupled resistors) and a capacitive element 197 (e.g. a single capacitor or a plurality of coupled capacitors). However, the present disclosure is not limited thereto. In general, the load 195 may be one of a resistive element, a capacitive element, an impedance element (e.g. capacitor, resistor, inductor or combination thereof), or a combination thereof.

The digital-to-analog conversion cell 180 may comprise additional circuitry not illustrated in Fig. 1. For example, the digital-to-analog conversion cell 180 may comprise an input node configured to receive the input signal 101 and logic circuitry coupled between the input node of the digital-to-analog conversion cell 180 and the inverter circuit 100. The logic circuitry may be configured to selectively supply the input signal 101 to the inverter circuit 100 based on one or more control (activation) signals of a control circuit of a DAC comprising the digital-to-analog conversion cell 180.

In the example of Fig. 1, one coupling path 160 is illustrated. However, it is to be noted that the present disclosure is not limited thereto. In other examples, a plurality of coupling paths (i.e. two or more coupling paths) each comprising a respective capacitive element may be provided. The plurality of coupling paths may be coupled between the source terminals of different transistor pairs, each of the different transistor pairs being formed by one of the plurality of transistors of the first conductivity type and one of the plurality of transistors of the second conductivity type.

In more general terms, an inverter circuit according to the present disclosure comprises at least one coupling path comprising a respective capacitive element, wherein the at least one coupling path is coupled between a source terminal of one of the plurality of transistors of the first conductivity type and a source terminal of one of the plurality of transistors of the second conductivity type.

Further exemplary inverter circuits comprising more than one coupling path will be described in the following with respect to Figs. 2 to 5.

**Fig. 2** illustrates a second example of a digital-to-analog conversion cell 181. The digital-to-analog conversion cell 181 is identical to the digital-to-analog conversion cell 180 described above except for the implementation of the inverter circuit. Therefore, only the differences between the inverter circuit 200 illustrated in Fig. 2 and the above described inverter circuit 100 will be described in the following.

While the inverter circuit 100 comprises two transistors 140-1 and 140-2 of the first conductivity type coupled in series and two transistors 150-1 and 150-2 of the second conductivity type coupled in series, the inverter circuit 200 comprises three transistors 140-1, 140-2 and 140-3 of the first conductivity type coupled in series and three transistors 150-1, 150-2 and 150-3 of the second conductivity type coupled in series.

The gate terminals of the transistors 140-1 and 150-3 are coupled to the fourth node 105 similar to what is described above. The gate terminals of the transistors 140-2, 140-3, 150-1 and 150-2 are configured to receive a respective fixed electrical potential 103-1, 103-2, 103-3 and 103-4 similar to what is described above.

The higher numbers of transistors of the first and second conductivity type allows to increase the potential difference between the first node 110 and the second node 120.

Further, the inverter circuit 200 comprises two coupling paths 160 and 161 instead of only one. The coupling path 160 is coupled to the source terminals of the transistors 140-3 and 150-1 at the nodes A and B such that its capacitive element 165 supports charging and discharging of the parasitic capacitances at the nodes A and B (illustrated by the parasitic capacitances 170-1 and 170-2). The coupling path 161 is coupled to the source terminals of the transistors 140-2 and 150-2 at the nodes C and D such that its capacitive element 166 supports charging and discharging of the parasitic capacitances at the nodes C and D (illustrated by the parasitic capacitances 170-3 and 170-4). The two coupling paths 160 and 161 allow to support charging and discharging of the parasitic capacitances present in the inverter circuit 200 in order to increase the linearity of the inverter circuit 200.

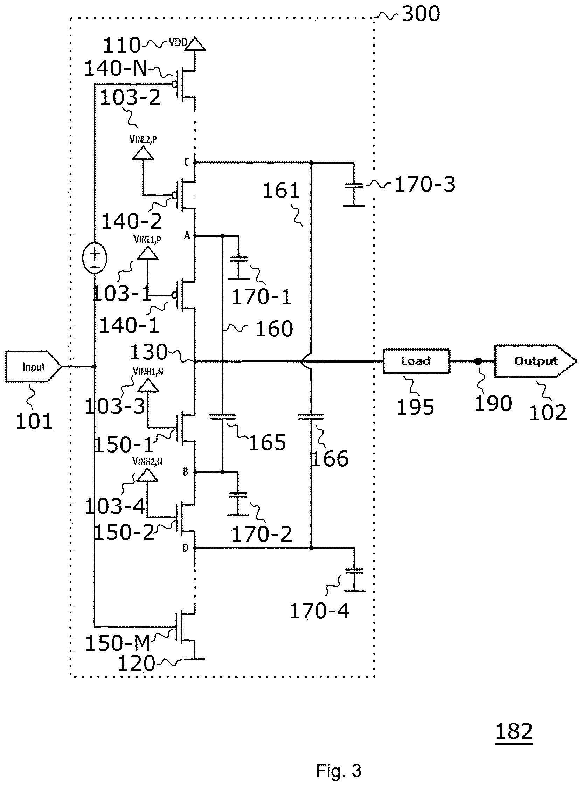

**Fig. 3** illustrates a third example of a digital-to-analog conversion cell 182. The digital-to-analog conversion cell 182 is identical to the digital-to-analog conversion cell 181 described above except for the implementation of the inverter circuit. Therefore, only the differences between the inverter circuit 300 illustrated in Fig. 3 and the above described inverter circuit 200 will be described in the following.

While the inverter circuit 200 comprises three transistors 140-1, 140-2 and 140-3 of the first conductivity type coupled in series and three transistors 150-1, 150-2 and 150-3 of the second conductivity type coupled in series, the inverter circuit 300 comprises N transistors 140-1, 140-2, ... 140-N coupled in series and M transistors 150-1, 150-2, ... 150-M coupled in series. As described above, any number N of transistors of the first conductivity type and any number M of transistors of the second conductivity type may be coupled in series, respectively. For example, the numbers N and M may be selected based on the (e.g. desired, target) potential difference between the first node 110 and the second node 120. Similar to what is described above, M may be identical to or be different from N.

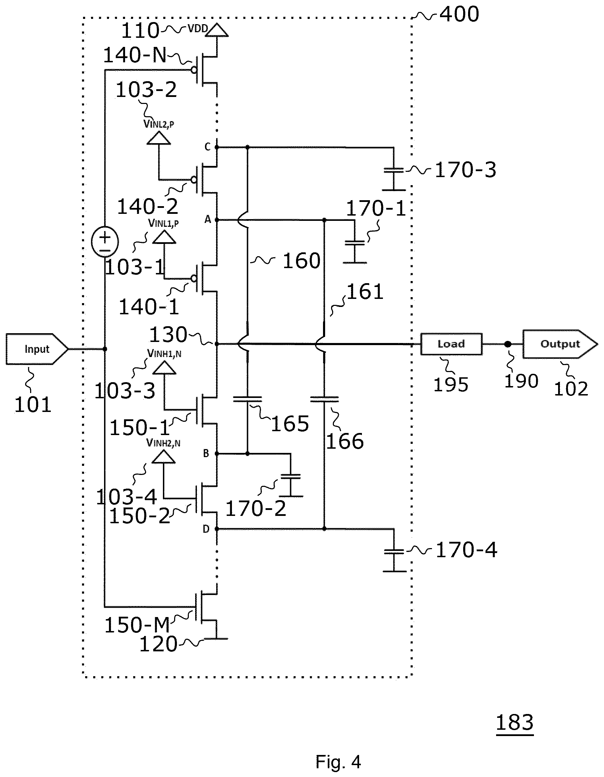

**Fig. 4** illustrates a fourth example of a digital-to-analog conversion cell 183. The digital-to-analog conversion cell 183 is identical to the digital-to-analog conversion cell 182 described above except for the implementation of the inverter circuit. Therefore, only the differences between the inverter circuit 400 illustrated in Fig. 4 and the above described inverter circuit 300 will be described in the following.

In the inverter circuit 300, the coupling path 160 is coupled to the source terminals of the transistors 140-1 and 150-1 at the nodes A and B and the coupling path 161 is coupled to the source terminals of the transistors 140-2 and 150-2 at the nodes C and D. In difference thereto, the coupling path 160 is coupled to the source terminals of the transistors 140-2 and 150-1 at the nodes B and C in the inverter circuit 400 such that its capacitive element 165 supports charging and discharging of the parasitic capacitances at the nodes B and C (illustrated by the parasitic capacitances 170-2 and 170-3). Further, the coupling path 161 is coupled to the source terminals of the transistors 140-1 and 150-2 at the nodes A and D in the inverter circuit 400 such its capacitive element 166 supports charging and discharging of the parasitic capacitances at the nodes A and D (illustrated by the parasitic capacitances 170-1 and 170-4).

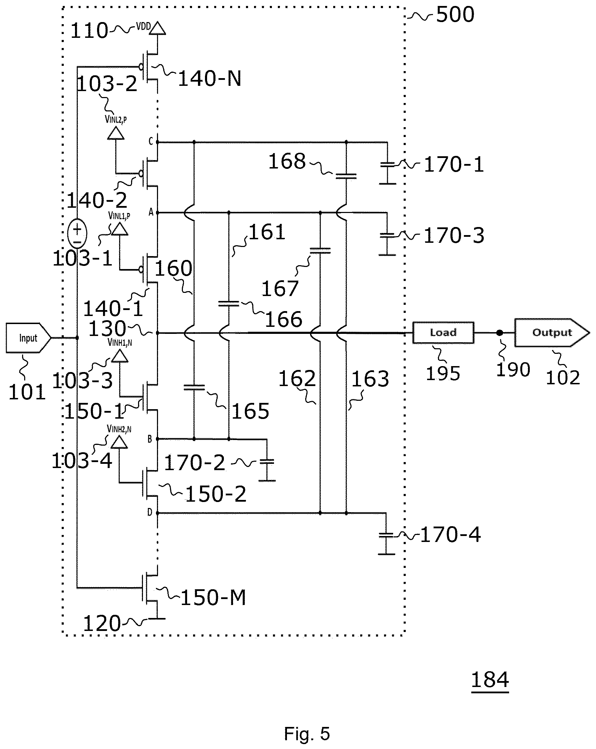

**Fig. 5** illustrates a fifth example of a digital-to-analog conversion cell 184. The digital-to-analog conversion cell 184 is identical to the digital-to-analog conversion cell 183 described above except for the implementation of the inverter circuit. Therefore, only the differences between the inverter circuit 500 illustrated in Fig. 5 and the above described inverter circuit 400 will be described in the following.

While the inverter circuit 400 comprises two coupling paths 160 and 161, the inverter circuit 400 comprises four coupling paths 160, 161, 162 and 163.

The coupling path 160 is coupled to the source terminals of the transistors 140-2 and 150-1 at the nodes B and C such that its capacitive element 165 supports charging and discharging of the parasitic capacitances at the nodes B and C (illustrated by the parasitic capacitances 170-1 and 170-2). The coupling path 161 is coupled to the source terminals of the transistors 140-1 and 150-1 at the nodes A and B such that its capacitive element 166 supports charging and discharging of the parasitic capacitances at the nodes A and B (illustrated by the parasitic capacitances 170-2 and 170-3). The coupling path 162 is coupled to the source terminals of the transistors 140-1 and 150-2 at the nodes A and D such that its capacitive element 167 supports charging and discharging of the parasitic capacitances at the nodes A and D (illustrated by the parasitic capacitances 170-3 and 170-4). The coupling path 163 is coupled to the source terminals of the transistors 140-2 and 150-2 at the nodes C and D such that its capacitive element 168 supports charging and discharging of the parasitic capacitances at the nodes C and D (illustrated by the parasitic capacitances 170-1 and 170-4).

It is apparent from the exemplary inverter circuits 200, 300, 400 and 500 described above that an inverter circuit according to present disclosure may comprises a plurality of coupling paths each comprising a respective capacitive element, wherein the plurality of coupling paths are coupled between the source terminals of different transistor pairs. Each of the different transistor pairs is formed by one of the plurality of transistors of the first conductivity type and one of the plurality of transistors of the second conductivity type. The coupling paths allow to support charging and discharging of the parasitic capacitances present in the inverter circuit in order to increase the linearity of the inverter circuit.

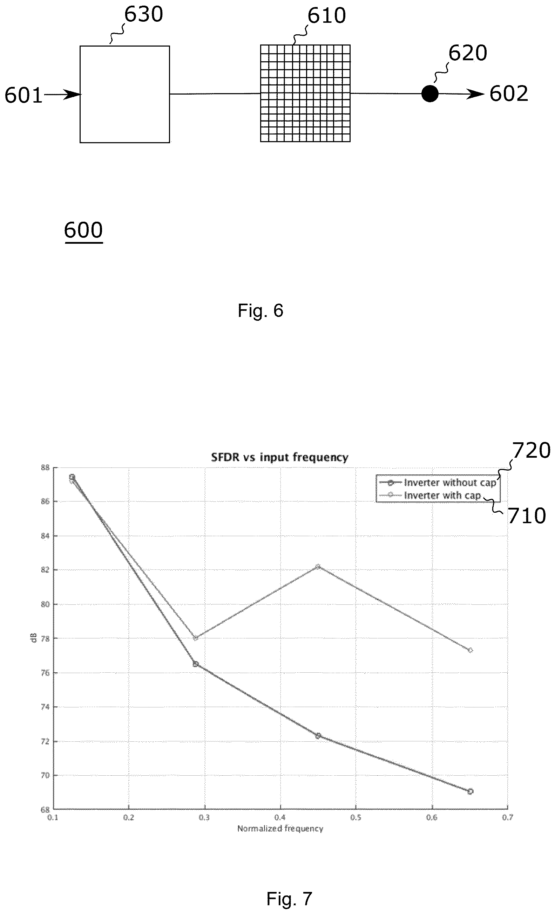

**Fig. 6** illustrates an example of a DAC 600 that uses digital-to-analog conversion cells according to the present disclosure.

The DAC 600 comprises a plurality of digital-to-analog conversion cells 610 (i.e. two or more digital-to-analog conversion cells). At least part of the plurality of digital-to-analog conversion cells 600 are implemented according to one or more aspects of the architecture described above in connection with Figs. 1 to 5 or one or more examples described above in connection with Figs. 1 to 5. The number of digital-to-analog conversion cells may, e.g., be based on a (desired, target) resolution of the DAC 600.

The output nodes of the plurality of digital-to-analog conversion cells 610 are coupled to a converter output node 620 of the DAC. The converter output node 620 is configured to provide an analog output signal 602 of the DAC based on the analog output signal of the plurality of digital-to-analog conversion cells 610. For example, the analog output signal of the plurality of digital-to-analog conversion cells 610 may be combined (e.g. summed) at the converter output node 620.

Further, the DAC 600 comprises a control circuit 630 configured to selectively activate one or more of the plurality of digital-to-analog conversion cells 610 based on a digital input signal 601 received by the DAC 600. For example, the control circuit 630 may selectively supply one or more control (activation) signals to the plurality of digital-to-analog conversion cells 610 for selectively activating one or more of the plurality of digital-to-analog conversion cells 610 based on the digital input signal 601.

Further, the control circuit 630 or any other circuitry of the DAC 600 may be configured to supply an (e.g. digital) control (activation) signal to the plurality of digital-to-analog conversion cells 610. For example, if the one or more control signals supplied to a respective one of the plurality of digital-to-analog conversion cells 610 indicate the respective digital-to-analog conversion cell is activated, respective logic circuitry of the digital-to-analog conversion cell may supply (forward) the control (activation)signal as input signal to the inverter circuit of the digital-to-analog conversion cell such that the control (activation)signal is inverted and drives the load of the digital-to-analog conversion cell for generating the analog output signal of the activated digital-to-analog conversion cell.

The plurality of digital-to-analog conversion cells 610 as well as the DAC 600 may optionally comprise further circuitry - conventional or custom.

Although a plurality of digital-to-analog conversion cells 610 is illustrated in Fig. 6, it is to be noted that in other examples, the DAC 600 may comprise only one digital-to-analog conversion cell according to the present disclosure such that the control circuit 630 may selectively activate the one digital-to-analog conversion cell based on the digital input signal 601. Accordingly, a DAC with a one bit resolution may be obtained.

Using at least one digital-to-analog conversion cell according to the present disclosure for the DAC 600 may allow to increase a linearity of the DAC 600 compared to conventional architectures. This is further illustrated in **Fig. 7** which shows a comparison of the SFDR of a DAC using conventional inverters without additional coupling paths and a DAC according to the present disclosure using at least one additional coupling path in the inverter circuit.

The curve 710 illustrates the course of the SFDR for the DAC according to the present disclosure over a normalized frequency range. As a reference, the curve 720 illustrates the course of the SFDR for the conventional DAC over the normalized frequency range.

As can be seen from Fig. 7, the SFDR (which is a measure for the linearity of a DAC) improves by up to 10 dB. In particular, the SFDR for the DAC according to the present disclosure is significantly improved compared to the SFDR for the conventional DAC for higher frequencies of the input signal.

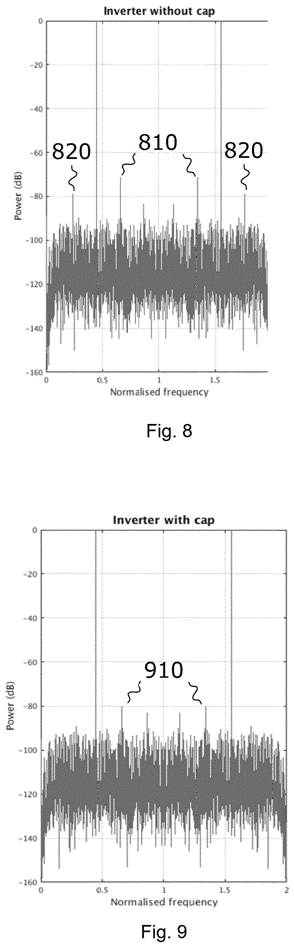

Further, Figs. 8 and 9 illustrate exemplary output spectra that show another beneficial effect of the at least one additional coupling path in the inverter. **Fig. 8** illustrates the output spectrum over a normalized frequency range of a DAC using conventional inverters without additional coupling path. **Fig. 9** illustrates the output spectrum over the normalized frequency range of a DAC according to the present disclosure using at least one additional coupling path in the inverter circuit. The input signal is the same for both DACs and varies from a few hundreds of MHz to 6 GHz. A power of the third harmonics 910 in the output spectrum of the DAC according to the present disclosure is significantly reduced compared to a power of the third harmonics 810 in the output spectrum of the conventional DAC. Also the fifth harmonics are significantly reduced. While the fifth harmonics 820 are clearly visible in the output spectrum of the conventional DAC, the fifth harmonics cannot be distinguished from the fundamental noise in the output spectrum of the DAC according to the present disclosure.

The proposed inverter circuit may allow to improve linearity beyond what is practically feasible because part of the charge is no longer lost to charging/discharging the parasitic capacitances when the input signal changes.

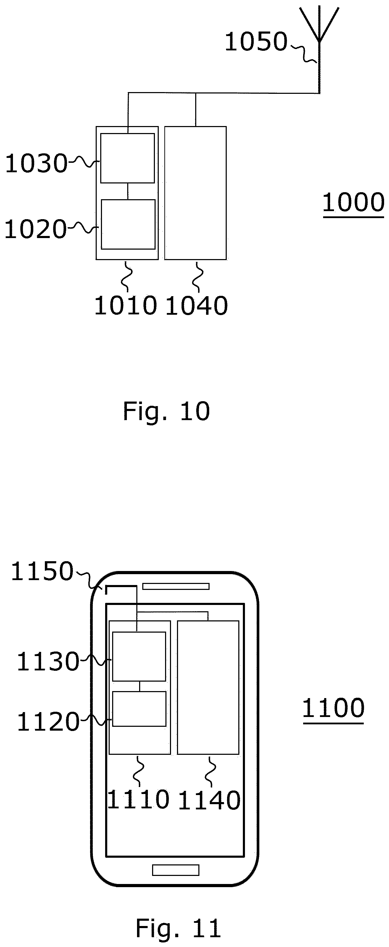

An example of an implementation using digital-to-analog conversion according to one or more aspects of the architecture described above in connection with Figs. 1 to 6 or one or more examples described above in connection with Figs. 1 to 6 is illustrated in **Fig. 10.** Fig. 10 schematically illustrates an example of a radio base station 1000 (e.g. for a femtocell, a picocell, a microcell or a macrocell) comprising a DAC 1030 as proposed.

A transmitter 1010 comprises the DAC 1030. Additionally, the transmitter 1010 comprises digital circuitry 1020. The DAC 1030 is coupled to the digital circuitry 1020. The digital circuitry 1020 is configured to output a digital signal which is converted to an analog signal by the DAC 1030. In other words, the analog output signal of the DAC 1030 is based on the digital signal. The analog output signal of the DAC 1030 may, e.g., be an analog Radio Frequency (RF) signal. For example, data to be wirelessly transmitted may be encoded in the digital signal.

The base station 1000 comprises at least one antenna element 1050 coupled to the transmitter 1010 for radiating an RF transmit signal to the environment. The RF transmit signal may be equal to the analog output signal of the DAC 1030 or be based on the analog output signal of the DAC 1030. For example, the transmitter 1010 may be coupled to the antenna element 1050 via one or more intermediate elements such as a filter, an up-converter (mixer) or a power amplifier.

Additionally, the base station 1000 comprises a receiver 1040 configured to receive a RF receive signal from the antenna element 1050 or another antenna element (not illustrated) of the base station 1000.

To this end, a base station with improved digital-to-analog conversion may be provided.

The base station 1000 may comprise further elements such as, e.g., an application processor, memory, a network controller, a user interface, power management circuitry, a satellite navigation receiver, a network interface controller or power tee circuitry.

In some aspects, the application processor may include one or more Central Processing Unit CPU cores and one or more of cache memory, a Low-DropOut (LDO) voltage regulator, interrupt controllers, serial interfaces such as Serial Peripheral Interface (SPI), Inter-Integrated Circuit (I²C) or universal programmable serial interface module, Real Time Clock (RTC), timer-counters including interval and watchdog timers, general purpose Input-Output (IO), memory card controllers such as Secure Digital (SD)/ MultiMedia Card (MMC) or similar, Universal Serial Bus (USB) interfaces, Mobile Industry Processor Interface Alliance (MIPI) interfaces and Joint Test Access Group (JTAG) test access ports.

In some aspects, the baseband processor may be implemented, for example, as a solder-down substrate including one or more integrated circuits, a single packaged integrated circuit soldered to a main circuit board or a multi-chip module containing two or more integrated circuits.

In some aspects, the memory may include one or more of volatile memory including Dynamic Random Access Memory (DRAM) and/or Synchronous Dynamic Random Access Memory (SDRAM), and Non-Volatile Memory (NVM) including high-speed electrically erasable memory (commonly referred to as Flash memory), Phase change Random Access Memory (PRAM), Magnetoresistive Random Access Memory (MRAM) and/or a three-dimensional crosspoint (3D XPoint) memory. The memory may be implemented as one or more of solder down packaged integrated circuits, socketed memory modules and plug-in memory cards.

In some aspects, the power management integrated circuitry may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, the power tee circuitry may provide for electrical power drawn from a network cable to provide both power supply and data connectivity to the base station using a single cable.

In some aspects, the network controller may provide connectivity to a network using a standard network interface protocol such as Ethernet. Network connectivity may be provided using a physical connection which is one of electrical (commonly referred to as copper interconnect), optical or wireless.

In some aspects, the satellite navigation receiver module may include circuitry to receive and decode signals transmitted by one or more navigation satellite constellations such as the Global Positioning System (GPS), GLObalnaya NAvigatSionnaya Sputnikovaya Sistema (GLONASS), Galileo and/or BeiDou. The receiver may provide data to the application processor which may include one or more of position data or time data. The application processor may use time data to synchronize operations with other radio base stations.

In some aspects, the user interface may include one or more of physical or virtual buttons, such as a reset button, one or more indicators such as Light Emitting Diodes (LEDs) and a display screen.

Another example of an implementation using digital-to-analog conversion according to one or more aspects of the architecture described above in connection with Figs. 1 to 6 or one or more examples described above in connection with Figs. 1 to 6 is illustrated in Fig. 11. Fig. 11 schematically illustrates an example of a mobile device 1100 (e.g. mobile phone, smartphone, tablet-computer, or laptop) comprising a DAC 1130 as proposed.

A transmitter 1110 comprises the DAC 1130. Additionally, the transmitter 1110 comprises digital circuitry 1120. The DAC 1130 is coupled to the digital circuitry 1120. The digital circuitry 1120 is configured to output a digital signal which is converted to an analog signal by the DAC 1130. In other words, the analog output signal of the DAC 1130 is based on the digital signal. The analog output signal of the DAC 1130 may, e.g., be an analog RF signal. For example, data to be wirelessly transmitted may be encoded in the digital signal.

The mobile device 1100 comprises at least one antenna element 1150 coupled to the transmitter 1110 for radiating an RF transmit signal to the environment. The RF transmit signal may be equal to the analog output signal of the DAC 1130 or be based on the analog output signal of the DAC 1130. For example, the transmitter 1110 may be coupled to the antenna element 1150 via one or more intermediate elements such as a filter, an up-converter (mixer) or a power amplifier.

Additionally, the mobile device 1100 comprises a receiver 1140 configured to receive a RF receive signal from the antenna element 1150 or another antenna element (not illustrated) of the mobile device 1100.

To this end, a mobile device with improved digital-to-analog conversion may be provided.

The mobile device 1100 may comprise further elements such as, e.g., a baseband processor, memory, a connectivity module, a Near Field Communication (NFC) controller, an audio driver, a camera driver, a touch screen, a display driver, sensors, removable memory, a power management integrated circuit or a smart battery.

In some aspects, the application processor may include, for example, one or more CPU cores and one or more of cache memory, LDO regulators, interrupt controllers, serial interfaces such as SPI, I²C or universal programmable serial interface module, RTC, timer-counters including interval and watchdog timers, general purpose input-output (IO), memory card controllers such as SD/MMC or similar, USB interfaces, MIPI interfaces and JTAG test access ports.

In some aspects, the baseband module may be implemented, for example, as a solder-down substrate including one or more integrated circuits, a single packaged integrated circuit soldered to a main circuit board, and/or a multi-chip module containing two or more integrated circuits.

The wireless communication circuits using digital-to-analog conversion according to the proposed architecture or one or more of the examples described above may be configured to operate according to one of the 3rd Generation Partnership Project (3GPP)-standardized mobile communication networks or systems. The mobile or wireless communication system may correspond to, for example, a 5^{th} Generation New Radio (5G NR), a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM), an Enhanced Data rates for GSM Evolution (EDGE) network, or a GSM/EDGE Radio Access Network (GERAN). Alternatively, the wireless communication circuits may be configured to operate according to mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wideband-CDMA (WCDMA) network, a Frequency Division Multiple Access (FDMA) network, a Spatial Division Multiple Access (SDMA) network, etc.

## Claims

1. An inverter circuit (100, 200, 300, 400, 500), comprising:
a first node (110) for coupling to a first electrical potential;
a second node (120) for coupling to a second electrical potential different from the first electrical potential;
a third node (130) configured to output an output signal of the inverter circuit;
a plurality of transistors of a first conductivity type (140-1, ..., 140-N) coupled in series between the first node (110) and the third node (130);
a plurality of transistors of a second conductivity type (150-1, ..., 150-M) coupled in series between the third node and the second node, the second conductivity type being different from the first conductivity type;
a fourth node (105) configured to receive an input signal (101) to be inverted, wherein the input signal (101) is a digital signal, wherein the fourth node (105) is coupled to a gate terminal of one of the plurality of transistors of the first conductivity type (140-1, ..., 140-N) and a gate terminal of one of the plurality of transistors of the second conductivity type (150-1, ..., 150-M), and wherein the gate terminals of the other transistors of the plurality of transistors of the first conductivity type (140-1, ..., 140-N) and the plurality of transistors of the second conductivity type (150-1, ..., 150-M) are configured to receive a respective fixed electrical potential; and
wherein a source terminal of the one of the plurality of transistors of the first conductivity type is coupled to the first node (110) and a source terminal of the one of the plurality of transistors of the second conductivity type is coupled to the second node (120); and
**characterized by**
at least one coupling path (160, ..., 163) comprising a capacitive element (165, ..., 168), wherein the at least one coupling path (160, ..., 163) is coupled between a source terminal of one of the other transistors of the plurality of transistors of the first conductivity type (140-1, ..., 140-N) and a source terminal of one of the other transistors of the plurality of transistors of the second conductivity type (150-1, ..., 150-M).

2. The inverter circuit (100, 200, 300, 400, 500) of claim 1, wherein a capacitance of the capacitive element (165, ..., 168) is equal to or greater than a gate-source capacitance of any of the plurality of transistors of the first conductivity type (140-1, ..., 140-N).

3. The inverter circuit (100, 200, 300, 400, 500) of claim 2, wherein the capacitance of the capacitive element (165, ..., 168) is at least three times and at maximum five times the gate-source capacitance of any of the plurality of transistors of the first conductivity type (140-1, ..., 140-N).

4. The inverter circuit (100, 200, 300, 400, 500) of any one of claims 1 to 3, wherein the inverter circuit (100, 200, 300, 400, 500) comprises a plurality of coupling paths (160, ..., 163) each comprising a respective capacitive element (165, ..., 168), wherein the plurality of coupling paths (160, ..., 163) are coupled between the source terminals of different transistor pairs, each of the different transistor pairs being formed by one of the other transistors of the plurality of transistors of the first conductivity type (140-1, ..., 140-N) and one of the other transistors of the plurality of transistors of the second conductivity type (150-1, ..., 150-M).

5. The inverter circuit (100, 200, 300, 400, 500) of any one of claims 1 to 4, wherein a frequency of the input signal (101) is above 1 GHz.

6. A digital-to-analog conversion cell (180, 181, 182, 183, 184) for a digital-to-analog converter, the digital-to-analog conversion cell (180, 181, 182, 183, 184) comprising:
an inverter circuit (100, 200, 300, 400, 500) according to any one of claims 1 to 5;
a cell output node (190) configured to provide an analog output signal of the digital-to-analog conversion cell (180, 181, 182, 183, 184); and
a load (195) coupled between the inverter circuit (100, 200, 300, 400, 500) and the cell output node (190).

7. The digital-to-analog conversion cell (180, 181, 182, 183, 184) of claim 6, wherein the load (195) is one of a resistive element (196), a capacitive element (197), an impedance element, or a combination thereof.

8. A digital-to-analog converter (600), comprising:
at least one digital-to-analog conversion cell (610) according to claim 6 or claim 7;
and
a converter output node (620) configured to provide an analog output signal (602) of the digital-to-analog converter (600) based on the analog output signal of the at least one digital-to-analog conversion cell (610).

9. The digital-to-analog converter (600) of claim 8, further comprising:
a control circuit (630) configured to selectively activate one or more of the at least one digital-to-analog conversion cell (610) based on a digital input signal (601) received by the digital-to-analog converter (600).

10. A transmitter (1010, 1110), comprising:
digital circuitry (1020, 1120) configured to output a digital signal; and
a digital-to-analog converter (1030, 1130) according to claim 8 or claim 9, wherein the analog output signal of the digital-to-analog converter (1030, 1130) is based on the digital signal.

11. The transmitter (1010, 1110) of claim 10, wherein data to be wirelessly transmitted are encoded in the digital signal.

12. A base station (1000), comprising:
a transmitter (1010) according to claim 10 or claim 11; and
at least one antenna element (1050) coupled to the transmitter.

13. A mobile device (1100), comprising:
a transmitter (1110) according to claim 10 or claim 11; and
at least one antenna element (1150) coupled to the transmitter.

## Patentansprüche

1. Wechselrichterschaltung (100, 200, 300, 400, 500), die umfasst:
einen ersten Knoten (110) zum Koppeln mit einem ersten elektrischen Potential;
einen zweiten Knoten (120) zum Koppeln mit einem zweiten elektrischen Potential, das sich vom ersten elektrischen Potential unterscheidet;
einen dritten Knoten (130), der dazu ausgelegt ist, ein Ausgangssignal der Wechselrichterschaltung auszugeben;
eine Mehrzahl von Transistoren eines ersten Leitfähigkeitstyps (140-1, ..., 140-N), die zwischen dem ersten Knoten (110) und dem dritten Knoten (130) in Reihe gekoppelt sind;
eine Mehrzahl von Transistoren eines zweiten Leitfähigkeitstyps (150-1, ..., 150-M), die zwischen dem dritten Knoten und dem zweiten Knoten in Reihe gekoppelt sind, wobei sich der zweite Leitfähigkeitstyp vom ersten Leitfähigkeitstyp unterscheidet;
einen vierten Knoten (105), der dazu ausgelegt ist, ein zu invertierendes Eingangssignal (101) zu empfangen, wobei das Eingangssignal (101) ein digitales Signal ist, wobei der vierte Knoten (105) mit einem Gate-Anschluss eines der Mehrzahl von Transistoren des ersten Leitfähigkeitstyps (140-1, ..., 140-N) und einem Gate-Anschluss eines der Mehrzahl von Transistoren des zweiten Leitfähigkeitstyps (150-1, ..., 150-M) gekoppelt ist und wobei die Gate-Anschlüsse der anderen Transistoren der Mehrzahl von Transistoren des ersten Leitfähigkeitstyps (140-1, ..., 140-N) und der Mehrzahl von Transistoren des zweiten Leitfähigkeitstyps (150-1, ..., 150-M) dazu ausgelegt sind, ein jeweiliges festes elektrisches Potential zu empfangen; und
wobei ein Source-Anschluss des einen der Mehrzahl von Transistoren des ersten Leitfähigkeitstyps mit dem ersten Knoten (110) gekoppelt ist und ein Source-Anschluss des einen der Mehrzahl von Transistoren des zweiten Leitfähigkeitstyps mit dem zweiten Knoten (120) gekoppelt ist; und
**gekennzeichnet durch**
mindestens einen Kopplungspfad (160, ..., 163), der ein kapazitives Element (165, ..., 168) umfasst, wobei der mindestens eine Kopplungspfad (160, ..., 163) zwischen einem Source-Anschluss eines der anderen Transistoren der Mehrzahl von Transistoren des ersten Leitfähigkeitstyps (140-1, ..., 140-N) und einem Source-Anschluss eines der anderen Transistoren der Mehrzahl von Transistoren des zweiten Leitfähigkeitstyps (150-1, ..., 150-M) gekoppelt ist.

2. Wechselrichterschaltung (100, 200, 300, 400, 500) nach Anspruch 1, wobei eine Kapazität des kapazitiven Elements (165, ..., 168) gleich einer oder größer als eine Gate-Source-Kapazität eines beliebigen der Mehrzahl von Transistoren des ersten Leitfähigkeitstyps (140-1, ..., 140-N) ist.

3. Wechselrichterschaltung (100, 200, 300, 400, 500) nach Anspruch 2,
wobei die Kapazität des kapazitiven Elements (165, ..., 168) mindestens das Dreifache und höchstens das Fünffache der Gate-Source-Kapazität eines beliebigen der Mehrzahl von Transistoren des ersten Leitfähigkeitstyps (140-1, ..., 140-N) ist.

4. Wechselrichterschaltung (100, 200, 300, 400, 500) nach einem der Ansprüche 1 bis 3,
wobei die Wechselrichterschaltung (100, 200, 300, 400, 500) eine Mehrzahl von Kopplungspfaden (160, ..., 163) umfasst, die jeweils ein jeweiliges kapazitives Element (165, ..., 168) umfassen, wobei die Mehrzahl von Kopplungspfaden (160, ..., 163) zwischen den Source-Anschlüssen verschiedener Transistorpaare gekoppelt sind, wobei jedes der unterschiedlichen Transistorpaare durch einen der anderen Transistoren der Mehrzahl von Transistoren des ersten Leitfähigkeitstyps (140-1, ..., 140-N) und einen der anderen Transistoren der Mehrzahl von Transistoren des zweiten Leitfähigkeitstyps (150-1, ..., 150-M) gebildet wird.

5. Wechselrichterschaltung (100, 200, 300, 400, 500) nach einem der Ansprüche 1 bis 4,
wobei eine Frequenz des Eingangssignals (101) über 1 GHz ist.

6. Digital-Analog-Umwandlungszelle (180, 181, 182, 183, 184) für einen Digital-Analog-Wandler, wobei die Digital-Analog-Umwandlungszelle (180, 181, 182, 183, 184) umfasst:
eine Wechselrichterschaltung (100, 200, 300, 400, 500) nach einem der Ansprüche 1 bis 5;
einen Zellenausgangsknoten (190), der dazu ausgelegt ist, ein analoges Ausgangssignal der Digital-Analog-Umwandlungszelle (180, 181, 182, 183, 184) bereitzustellen; und
eine Last (195), die zwischen der Wechselrichterschaltung (100, 200, 300, 400, 500) und dem Zellenausgangsknoten (190) gekoppelt ist.

7. Digital-Analog-Umwandlungszelle (180, 181, 182, 183, 184) nach Anspruch 6,
wobei die Last (195) eines von einem Widerstandselement (196), einem kapazitiven Element (197), einem Impedanzelement oder einer Kombination davon ist.

8. Digital-Analog-Wandler (600), der umfasst:
mindestens eine Digital-Analog-Umwandlungszelle (610) nach Anspruch 6 oder Anspruch 7 und
einen Wandlerausgangsknoten (620), der dazu ausgelegt ist, ein analoges Ausgangssignal (602) des Digital-Analog-Wandlers (600) basierend auf dem analogen Ausgangssignal der mindestens einen Digital-Analog-Umwandlungszelle (610) bereitzustellen.

9. Digital-Analog-Wandler (600) nach Anspruch 8, der ferner umfasst:
eine Steuerschaltung (630), die dazu ausgelegt ist, eine oder mehrere der mindestens einen Digital-Analog-Umwandlungszelle (610) basierend auf einem digitalen Eingangssignal (601), das durch den Digital-Analog-Wandler (600) empfangen wird, selektiv zu aktivieren.

10. Sender (1010, 1110), der umfasst:
eine digitale Schaltungsanordnung (1020, 1120), die dazu ausgelegt ist, ein digitales Signal auszugeben; und
einen Digital-Analog-Wandler (1030, 1130) nach Anspruch 8 oder Anspruch 9, wobei das analoge Ausgangssignal des Digital-Analog-Wandlers (1030, 1130) auf dem digitalen Signal basiert.

11. Sender (1010, 1110) nach Anspruch 10, wobei Daten, die drahtlos übertragen werden sollen, im digitalen Signal codiert sind.

12. Basisstation (1000), die umfasst:
einen Sender (1010) nach Anspruch 10 oder Anspruch 11 und mindestens ein Antennenelement (1050), das mit dem Sender gekoppelt ist.

13. Mobile Vorrichtung (1100), die umfasst:
einen Sender (1110) nach Anspruch 10 oder Anspruch 11 und mindestens ein Antennenelement (1150), das mit dem Sender gekoppelt ist.

## Revendications

1. Circuit inverseur (100, 200, 300, 400, 500), comprenant :
un premier nœud (110) pour le couplage à un premier potentiel électrique ;
un deuxième nœud (120) pour le couplage à un deuxième potentiel électrique différent du premier potentiel électrique ;
un troisième nœud (130) configuré pour délivrer en sortie un signal de sortie du circuit inverseur ;
une pluralité de transistors d'un premier type de conductivité (140-1, ..., 140-N) couplés en série entre le premier nœud (110) et le troisième nœud (130) ;
une pluralité de transistors d'un deuxième type de conductivité (150-1, ..., 150-M) couplés en série entre le troisième nœud et le deuxième nœud, le deuxième type de conductivité étant différent du premier type de conductivité ;
un quatrième nœud (105) configuré pour recevoir un signal d'entrée (101) à inverser, où le signal d'entrée (101) est un signal numérique, où le quatrième nœud (105) est couplé à une borne de grille de l'un de la pluralité de transistors du premier type de conductivité (140-1, ..., 140-N) et une borne de grille de l'un de la pluralité de transistors du deuxième type de conductivité (150-1, ..., 150-M), et où les bornes de grille des autres transistors de la pluralité de transistors du premier type de conductivité (140-1, ..., 140-N) et de la pluralité de transistors du deuxième type de conductivité (150-1, ..., 150-M) sont configurées pour recevoir un potentiel électrique fixe respectif ; et
où une borne de source de l'un de la pluralité de transistors du premier type de conductivité est couplée au premier nœud (110) et une borne de source de l'un de la pluralité de transistors du deuxième type de conductivité est couplée au deuxième nœud (120) ; et
**caractérisé par**
au moins un chemin de couplage (160, ..., 163) comprenant un élément capacitif (165, ..., 168), où l'au moins un chemin de couplage (160, ..., 163) est couplé entre une borne de source de l'un des autres transistors de la pluralité de transistors du premier type de conductivité (140-1, ..., 140-N) et une borne de source de l'un des autres transistors de la pluralité de transistors du deuxième type de conductivité (150-1, ..., 150-M).

2. Circuit inverseur (100, 200, 300, 400, 500) selon la revendication 1, dans lequel une capacité de l'élément capacitif (165, ..., 168) est égale ou supérieure à une capacité grille-source de l'un quelconque de la pluralité de transistors du premier type de conductivité (140-1, ..., 140-N).

3. Circuit inverseur (100, 200, 300, 400, 500) selon la revendication 2,
dans lequel la capacité de l'élément capacitif (165, ..., 168) est au moins trois fois et au maximum cinq fois la capacité grille-source de l'un quelconque de la pluralité de transistors du premier type de conductivité (140-1, ..., 140-N).

4. Circuit inverseur (100, 200, 300, 400, 500) selon l'une quelconque des revendications 1 à 3,
dans lequel le circuit inverseur (100, 200, 300, 400, 500) comprend une pluralité de chemins de couplage (160, ..., 163) comprenant chacun un élément capacitif respectif (165, ..., 168), où la pluralité de chemins de couplage (160, ..., 163) sont couplés entre les bornes de source de différentes paires de transistors, chacune des différentes paires de transistors étant formée par l'un des autres transistors de la pluralité de transistors du premier type de conductivité (140-1, ..., 140-N) et l'un des autres transistors de la pluralité de transistors du deuxième type de conductivité (150-1, ..., 150-M).

5. Circuit inverseur (100, 200, 300, 400, 500) selon l'une quelconque des revendications 1 à 4,
dans lequel une fréquence du signal d'entrée (101) est supérieure à 1 GHz.

6. Cellule de conversion numérique-analogique (180, 181, 182, 183, 184) pour un convertisseur numérique-analogique, la cellule de conversion numérique-analogique (180, 181, 182, 183, 184) comprenant :
un circuit inverseur (100, 200, 300, 400, 500) selon l'une quelconque des revendications 1 à 5 ;
un nœud de sortie de cellule (190) configuré pour fournir un signal de sortie analogique de la cellule de conversion numérique-analogique (180, 181, 182, 183, 184) ; et
une charge (195) couplée entre le circuit inverseur (100, 200, 300, 400, 500) et le nœud de sortie de cellule (190).

7. Cellule de conversion numérique-analogique (180, 181, 182, 183, 184) selon la revendication 6,
dans lequel la charge (195) est l'un d'un élément résistif (196), d'un élément capacitif (197), d'un élément d'impédance ou une combinaison de ceux-ci.

8. Convertisseur numérique-analogique (600), comprenant :
au moins une cellule de conversion numérique-analogique (610) selon la revendication 6 ou la revendication 7 ; et
un nœud de sortie de convertisseur (620) configuré pour fournir un signal de sortie analogique (602) du convertisseur numérique-analogique (600) sur la base du signal de sortie analogique de l'au moins une cellule de conversion numérique-analogique (610).

9. Convertisseur numérique-analogique (600) selon la revendication 8, comprenant en outre :
un circuit de commande (630) configuré pour activer sélectivement une ou plusieurs de l'au moins une cellule de conversion numérique-analogique (610) sur la base d'un signal d'entrée numérique (601) reçu par le convertisseur numérique-analogique (600).

10. Émetteur (1010, 1110), comprenant :
des circuits numériques (1020, 1120) configurés pour délivrer en sortie un signal numérique ; et
un convertisseur numérique-analogique (1030, 1130) selon la revendication 8 ou la revendication 9, où le signal de sortie analogique du convertisseur numérique-analogique (1030, 1130) est basé sur le signal numérique.

11. Émetteur (1010, 1110) selon la revendication 10, dans lequel les données à transmettre sans fil sont codées dans le signal numérique.

12. Station de base (1000), comprenant :
un émetteur (1010) selon la revendication 10 ou la revendication 11 ; et
au moins un élément d'antenne (1050) couplé à l'émetteur.

13. Dispositif mobile (1100), comprenant :
un émetteur (1110) selon la revendication 10 ou la revendication 11 ; et
au moins un élément d'antenne (1150) couplé à l'émetteur.
